(19) Europäisches Patentamt
European Patent Office
Office européen des brevets

(11) Veröffentlichungsnummer: **0 384 940 B1**

(12) # EUROPÄISCHE PATENTSCHRIFT

(45) Veröffentlichungstag der Patentschrift: **22.06.94**

(51) Int. Cl.⁵: **C08G 59/30**, C08G 59/32, C08G 59/50, H05K 1/03

(21) Anmeldenummer: **89103802.8**

(22) Anmeldetag: **03.03.89**

(54) **Epoxidharzmischungen.**

(43) Veröffentlichungstag der Anmeldung:
**05.09.90 Patentblatt 90/36**

(45) Bekanntmachung des Hinweises auf die Patenterteilung:
**22.06.94 Patentblatt 94/25**

(84) Benannte Vertragsstaaten:
**AT BE CH DE FR GB IT LI NL SE**

(56) Entgegenhaltungen:
**EP-A- 0 274 646**

**CHEMICAL ABSTRACTS, Band 94, Nr. 24, 15. Juni 1981, Seite 37, rechte Spalte, Zusammenfassung nr. 193199u, Columbus, Ohio, USA; B.M. ZUEV et al.: "Adhesive composition" & USSR 794054**

**CHEMICAL ABSTRACTS, Band 91, Nr. 6, 6. August 1979, Seite 22, linke Spalte, Zusammenfassung Nr. 40180u, Columbus, Ohio, USA; D.A. KOURTIDES et al.: "advanced resin matrixes for fire resistant composites" & Annu. Pac. Tech. Conf. Tech. Disp. (Tech. Pap.) (Soc. Plast. Eng.) 1979, Band 4, Seiten 51-54**

(73) Patentinhaber: **SIEMENS AKTIENGESELLSCHAFT**
**Wittelsbacherplatz 2**
**D-80333 München(DE)**

(72) Erfinder: **v. Gentzkow, Wolfgang, Dr., Dipl.-Chem.**
**Zwetschgenweg 1**
**D-8524 Kleinsendelbach(DE)**
Erfinder: **Huber, Jürgen**
**Am Heiligenholz 6**
**D-8520 Erlangen(DE)**
Erfinder: **Rogler, Wolfgang, Dr., Dipl.-Chem.**
**Frankenstrasse 44b**
**D-8521 Möhrendorf(DE)**
Erfinder: **Wilhelm, Dieter, Dr., Dipl.-Chem.**
**Bergstrasse 32b**
**D-8550 Forchheim(DE)**

**EP 0 384 940 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

CHEMICAL ABSTRACTS, Band 99, Nr. 26, 26. Dezember 1983, Seite 34, rechte Spalte, Zusammenfassung Nr. 213394n, Columbus, Ohio, USA; V.N. ARTEMOV et al.: "Reactice phosphorus-containing organic compounds as effective fireproofing agents for strong hard-to-burn epoxy polymers" & Plast. Massy 1983, Nr. 9, Seiten 44-46

CHEMICAL ABSTRACTS, Band 106, nr. 18, 4. Mai 1987, Seite 19, linke Spalte, Zusammenfassung Nr. 139155e, Columbus, Ohio, USA; E.F. GUBANOV et al.: "Phosphorus-containing epoxides and their polymers" & Vysokomol. Soedin. Ser. B 1987, Band 29, Nr. 1, Seiten 45-47

## Beschreibung

Die Erfindung betrifft Epoxidharzmischungen zur Herstellung von Prepregs und Verbundwerkstoffen sowie aus diesen Epoxidharzmischungen hergestellte Prepregs und Verbundwerkstoffe.

Verbundwerkstoffe auf der Basis von Epoxidharzen und anorganischen oder organischen Verstärkungsmaterialien haben in vielen Bereichen der Technik und des täglichen Lebens eine hohe Bedeutung erlangt. Gründe dafür sind einerseits die relativ einfache und sichere Verarbeitung der Epoxidharze und andererseits das gute mechanische und chemische Eigenschaftsniveau der gehärteten Epoxidharz-Formstoffe, das eine Anpassung an unterschiedliche Einsatzzwecke und eine vorteilhafte Nutzung der Eigenschaften aller am Verbund beteiligten Werkstoffe gestattet.

Die Verarbeitung der Epoxidharze zu Verbundwerkstoffen erfolgt vorteilhaft über die Herstellung von Prepregs. Zu diesem Zweck werden anorganische oder organische Verstärkungsmaterialien bzw. Einlagerungskomponenten in Form von Fasern, Vliesen und Geweben oder von Flächenstoffen mit dem Harz getränkt. In den meisten Fällen geschieht dies mit einer Lösung des Harzes in einem leicht verdampf- oder verflüchtigbaren Lösungsmittel. Die dabei erhaltenen Prepregs dürfen nach diesem Prozeß nicht mehr klebend, aber auch noch nicht ausgehärtet sein, vielmehr soll sich die Harzmatrix lediglich in einem vorpolymerisierten Zustand befinden. Außerdem müssen die Prepregs ausreichend lagerstabil sein. So wird beispielsweise für die Herstellung von Leiterplatten eine Lagerstabilität von mindestens 3 Monaten gefordert. Bei der Weiterverarbeitung zu Verbundwerkstoffen müssen die Prepregs außerdem bei Temperaturerhöhung aufschmelzen und sich mit den Verstärkungsmaterialien bzw. Einlagerungskomponenten sowie mit den für den Verbund vorgesehenen Werkstoffen unter Druck möglichst fest und dauerhaft verbinden, d.h. die vernetzte Epoxidharzmatrix muß eine hohe Grenzflächenhaftung zu den Verstärkungsmaterialien sowie zu den zu verbindenden Materialien, wie metallischen, keramischen, mineralischen und organische Materialien, ausbilden.

Im gehärteten Zustand wird von den Verbundwerkstoffen generell hohe mechanische und thermische Festigkeit sowie chemische Beständigkeit und Wärmeformbeständigkeit bzw. Alterungsbeständigkeit gefordert. Für elektrotechnische und elektronische Anwendungen kommt die Forderung nach dauerhaft hohen elektrischen Isolationseigenschaften und für spezielle Einsatzzwecke eine Vielzahl von zusätzlichen Forderungen hinzu. Für den Einsatz als Leiterplattenmaterial sind beispielsweise hohe Dimensionsstabilität über einen weiten Temperaturbereich, gutes Haftvermögen zu Glas und Kupfer, hoher Oberflächenwiderstand, geringer dielektrischer Verlustfaktor, gutes Bearbeitungsverhalten (Stanzbarkeit, Bohrbarkeit), geringe Wasseraufnahme und hohe Korrosionsbeständigkeit erforderlich.

Mit zunehmender Belastung und intensiver Nutzung der Verbundwerkstoffe erhält vor allem die Forderung nach Wärmeformbeständigkeit besonderes Gewicht. Dies bedeutet, daß die Materialien während der Verarbeitung und Nutzung hohen Temperaturen ohne Verformung oder Schädigung des Verbundes, beispielsweise durch Delaminierung, widerstehen müssen. Leiterplatten werden beispielsweise beim Schwallöten einer Temperatur von 270 °C ausgesetzt. Ebenso können beim Schneiden und Bohren örtlich kurzzeitig Temperaturen von über 200 °C auftreten. Ein günstiges Verhalten zeigen dabei Materialien mit einer hohen Glasübergangstemperatur $T_G$. Liegt diese über den genannten Werten, so ist im gesamten bei der Bearbeitung überstrichenen Temperaturbereich Formstabilität gewährleistet und Schädigungen, wie verwölbung und Delaminierung, sind weitgehend ausgeschlossen. Das derzeit weltweit für FR4-Laminate im großen Maßstab eingesetzte Epoxidharz weist nach der Härtung eine Glasübergangstemperatur von nur 130 °C auf. Dies führt aber zu den beschriebenen Schädigungen und Ausfällen bei der Fertigung. Es besteht daher schon lange der Wunsch, vergleichbar gut verarbeitbare und kostengünstige Materialien mit einer Glasübergangstemperatur von über 200 °C zur Verfügung zu haben.

Eine weitere Forderung, die in letzter Zeit zunehmende Bedeutung erlangt, ist die Forderung nach Schwerbrennbarkeit. In vielen Bereichen kommt dieser Forderung - wegen der Gefährdung von Menschen und Sachwerten - erste Priorität zu, beispielsweise bei Konstruktionswerkstoffen für den Flugzeug- und Kraftfahrzeugbau und für öffentliche Verkehrsmittel. Bei den elektrotechnischen und insbesondere den elektronischen Anwendungen ist die Schwerbrennbarkeit von Leiterplattenmaterialien- wegen der hohen Werte der darauf montierten elektronischen Bauelemente - unverzichtbar.

Zur Beurteilung des Brennverhaltens muß deshalb eine der härtesten Materialprüfnormen bestanden werden, nämlich die V-O-Einstufung nach UL 94V. Bei dieser Prüfung wird ein Prüfkörper vertikal am unteren Rand mit einer definierten Flamme beflammt. Die Summe der Brennzeiten von 10 Prüfungen darf 50 s nicht überschreiten. Diese Forderung ist schwer zu erfüllen, vor allem wenn es, wie in der Elektronik üblich, um dünne Wandstärken geht. Das weltweit im technischen Einsatz für FR4-Laminate befindliche Epoxidharz erfüllt diese Forderungen nur, weil es, auf das Harz bezogen, ca. 30 bis 40 % kernbromierte aromatische Epoxid-Komponente, d.h. ca. 17 bis 21 % Brom, enthält. Für andere Einsatzzwecke werden

vergleichbar hohe Konzentrationen an Halogenverbindungen eingesetzt und oft noch mit Antimontrioxid als Synergist kombiniert. Die Problematik bei diesen Verbindungen besteht darin, daß sie einerseits zwar als Flammschutzmittel hervorragend wirksam sind, andererseits aber auch sehr bedenkliche Eigenschaften besitzen. So steht Antimontrioxid auf der Liste der krebserzeugenden Chemikalien, und aromatische Bromverbindungen spalten bei der thermischen Zersetzung nicht nur Bromradikale und Bromwasserstoff ab, die zu starker Korrosion führen, bei der Zersetzung in Gegenwart von Sauerstoff können insbesondere die hochbromierten Aromaten vielmehr auch die hochtoxischen Polybromdibenzofurane und Polybromdibenzodioxine bilden. Erhebliche Schwierigkeiten bereitet desweiteren die Entsorgung von bromhaltigen Altwerkstoffen und Giftmüll.

Materialien, die der Forderung nach erhöhter Wärmeformbeständigkeit entgegenkommen oder diese sogar erfüllen, sind beispielsweise Formstoffe auf der Basis Bismaleinimid/Triazin (BT) mit einer $T_G$ von ca. 200 °C oder Polyimid (PI) mit einer $T_G$ von 260 bis 270 °C. Neuerdings werden auch BT/Epoxy-Blends mit einer $T_G$ von 180 °C angeboten. Mit diesen Harzsystemen hergestellte Laminate zeigen jedoch ein schlechteres Ver- und Bearbeitungsverhalten als Laminate auf Epoxidharzbasis. So erfordert beispielsweise die Herstellung von Laminaten auf Polyimidbasis Preßtemperaturen von ca. 230 °C und wesentlich längere Nachhärtezeiten (ca. 8 h) bei Temperaturen von 230 °C. Wesentliche Nachteile der Polyimide sind außerdem die geringe interlaminare Haftung, die beim Stanzen zur Delaminierung führt und wesentlich teurere und zeitaufwendigere Bearbeitungsprozesse, wie Sägen oder Fräsen, erfordert, sowie die hohe Feuchtigkeitsaufnahme, die eine aufwendige Trocknung (2 h bei 120 bis 140 °C) von Laminaten und Prepregs vor dem Verpressen notwendig macht. Hinzu kommt noch, daß bei der Bearbeitung von Formstoffen auf PI- und BT-Basis ein höherer Bohrerverschleiß beim Anfertigen der Bestückungslöcher auftritt. Ein weiterer wesentlicher Nachteil dieser Harzsysteme ist ihr 6- bis 10mal höherer Materialpreis.

Ein vergleichsweise kostengünstiges Harzsystem wird erhalten, wenn aromatische und/oder heterocyclische Polyepoxidharze, d.h. Polyglycidylverbindungen, mit aromatischen Polyaminen als Härter kombiniert werden. Derartige Polyamine, die beispielsweise aus der DE-PS 27 43 680 bekannt sind, führen zu besonders wärmeformbeständigen, alterungsstabilen Netzwerkpolymeren. Der EP-OS 0 274 646 ist zu entnehmen, daß bei Verwendung von 1.3.5-Tris(3-amino-4-alkylphenyl)-2.4.6-trioxo-hexahydrotriazinen als Härter Laminate erhalten werden, die Glasübergangstemperaturen bis 245 °C aufweisen und sich durch ein gutes Ver- und Bearbeitungsverhalten auszeichnen.

Auch wenn die genannten Harzsysteme ein recht unterschiedliches Brennverhalten aufweisen, gilt für alle der Nachteil, inhärent nicht ausreichend schwerbrennbar zu sein. Zur Erfüllung der für viele Einsatzzwecke unverzichtbaren Forderung, die Brandprüfung nach UL 94V mit der Einstufung V-O zu bestehen, kann deshalb auf den Einsatz von hochwirksamen bromhaltigen Flammschutzmitteln nicht verzichtet werden. Dies hat zur Folge, daß einerseits das mit Bromverbindungen verbundene Gefährdungspotential und andererseits eine durch die Bromverbindungen hervorgerufene Verschlechterung des thermisch-mechanischen Eigenschaftsniveaus in Kauf genommen werden muß. Es ist nämlich bekannt, daß der Zusatz kernbromierter Aromaten eine Reduzierung der Glasübergangstemperatur bewirkt. So wurde beispielsweise gefunden, daß die Glasübergangstemperatur von Polyimiden durch Zugabe von Bromverbindungen um 40 bis 70 °C reduziert wird (siehe: "Polymer Journal", Vol. 20 (1988), Seiten 125 ff.). Bei den in der EP-OS 0 274 646 beschriebenen Systemen aus Epoxiden und Polyaminen wird bei teilweisem Ersatz der Epoxidkomponente durch die entsprechende bromierte Verbindung, entsprechend einem Gesamtbromgehalt von 4 %, eine Reduktion der $T_G$ um ca. 50 °C auf Werte von unter 200 °C gefunden.

Aus diesen Gründen hat es nicht an Versuchen gefehlt, die bromhaltigen Flammschutzmittel durch weniger problematische Substanzen zu ersetzen. So wurden beispielsweise Füllstoffe mit Löschgaswirkung, wie Aluminiumoxidhydrate (siehe: "J. Fire and Flammability", Vol. 3 (1972), Seiten 51 ff.), basische Aluminiumcarbonate (siehe: "Plast. Engng.", Vol. 32 (1976), Seiten 41 ff.) und Magnesiumhydroxide (EP-OS 0 243 201), sowie verglasende Füllstoffe, wie Borate (siehe: "Modern Plastics", Vol. 47 (1970), No.6, Seiten 140 ff.) und Phosphate (US-PS 2 766 139 und 3 398 019), vorgeschlagen. Allen diesen Füllstoffen haftet aber der Nachteil an,daß sie die mechanischen, chemischen und elektrischen Eigenschaften der Verbundwerkstoffe zum Teil erheblich verschlechtern. Außerdem erfordern sie spezielle, meist aufwendigere Verarbeitungstechniken, da sie zur Sedimentation neigen und die Viskosität des gefüllten Harzsystems erhöhen.

Es ist auch schon die flammhemmende Wirksamkeit von rotem Phosphor beschrieben worden (GB-PS 1 112 139), gegebenenfalls in Kombination mit feinstverteiltem Siliciumdioxid oder Aluminiumoxidhydrat (US-PS 3 373 135). Dabei werden Werkstoffe erhalten, die - wegen der in Gegenwart von Feuchtigkeit entstehenden Phosphorsäure und der damit verbundenen Korrosion - den Einsatz für elektrotechnische und elektronische Zwecke einschränken. Desweiteren wurden bereits organische Phosphorverbindungen, wie Phosphorsäureester, Phosphonsäureester und Phosphine, als flammhemmende Additive vorgeschlagen

(siehe: W.C. Kuryla und A.J. Papa "Flame Retardancy of Polymeric Materials", Vol. 1, Seiten 24 bis 38 und 52 bis 61, Marcel Dekker Inc., New York, 1973). Da diese Verbindungen für ihre "weichmachenden" Eigenschaften bekannt sind und als Weichmacher für Polymere weltweit in großem Maßstab verwendet werden (GB-PS 10 794), ist auch diese Alternative wenig erfolgversprechend.

Zur flammhemmenden Einstellung von Epoxidharzen können auch Phosphorverbindungen, wie epoxidgruppenhaltige Phosphorverbindungen, dienen, die im Epoxidharz-Netzwerk verankerbar sind. Allerdings ist ein Großteil dieser Verbindungen flüssig oder kristallin und kommt deshalb für die schwerbrennbare Einstellung von Epoxidharzen nicht in Frage, da sie entweder den Erweichungspunkt der Festharze stark herabsetzen, Klebrigkeit bewirken oder - im Falle von kristallinen Verbindungen - wieder auskristallisieren (siehe: DE-OS 25 38 675). Epoxidgruppenhaltige Phosphorverbindungen werden deshalb in allen bekannten Arbeiten zunächst in einer Vorreaktion mit Bisphenolen oder Phenolharzen (DE-OS 25 38 675 und JP-OS 58-185631), mit Dicarbonsäuren (siehe: "Vysokomol. Soedin.", Ser. B. 29 (1), Seiten 45 bis 47 (1987)) oder mit Polyesterharzen aus Dihydroxyverbindungen und Dicarbonsäuren (JP-OS 50-043221) umgesetzt und erst dann in Mischung mit den Epoxidharzen - überwiegend ionisch - gehärtet. Die dabei erreichte Schwerbrennbarkeit ist allerdings gering. So werden beispielsweise an Harzen, die durch eine Vorreaktion mit Bisphenolen erhalten wurden, LOI-Werte (Limiting Oxygen Index) von 23,5 bis 24 erreicht (siehe: DE-OS 25 38 675), d.h. Werte, wie man sie bei durchaus brennbaren Materialien, wie Wolle (LOI = 25), findet, während die LOI-Werte für bekanntermaßen schwerbrennbare Materialien, wie Polysulfon (LOI = 30), Polyvinylchlorid (LOI = 42), Polyvinylidenchlorid (LOI = 60) und Polytetrafluorethylen (LOI = 95), wesentlich höher liegen (siehe: D.W. v. Krevelen "Properties of Polymers", Elsevier Scientific Publishing Comp., Amsterdam, Oxford, New York, 1976, Seiten 525 ff.). Im Falle der Umsetzungsprodukte von Polyesterharzen mit Triglycidylphosphaten (siehe: JP-OS 50-043221) müssen zur schwerbrennbaren Einstellung von Polyesterfasern sogar Halogenverbindungen und Antimontrioxid hinzugegeben werden.

Auch die thermisch-mechanischen Eigenschaften der bei der Härtung erhaltenen Formstoffe sind nicht ausreichend. So wird beispielsweise bei der aminischen Härtung von Epoxidharzen aus Methyl-diglycidylphosphonat und Dicarbonsäuren eine $T_G$ von 45 bis 80 °C erhalten (siehe: "Vysokomol. Soedin.", Ser. B. 29 (1), Seiten 45 bis 47 (1987)). Dies stimmt mit der Erfahrung überein, daß Phosphorsäureestergruppierungen, sowohl in der Polymerhauptkette als auch in der Seitenkette, grundsätzlich eine Weichmachung und damit eine Senkung der Glasübergangstemperatur bewirken (siehe: "Journal of Macromolecular Science", Vol. Cl, No. 1 (1967), Seiten 1 ff.).

Aufgabe der Erfindung ist es, Epoxidharzmischungen zur Herstellung von Prepregs und Verbundwerkstoffen anzugeben, die kostengünstig zugänglich und vergleichbar den im technischen Einsatz befindlichen Epoxidharzen verarbeitbar sind und - ohne Zusatz von Halogenverbindungen oder Antimontrioxid - schwerbrennbare, d.h. entsprechend UL 94V nach V-O einstufbare Formstoffe bzw. Verbundwerkstoffe mit einer möglichst hohen Glasübergangstemperatur ($\gg$ 200 °C) liefern.

Dies wird erfindungsgemäß dadurch erreicht, daß die Epoxidharzmischungen folgende Komponenten enthalten:

(A) ein phosphorfreies aromatisches und/oder heterocyclisches Polyepoxidharz, gegebenenfalls in Abmischung mit einem aliphatischen Epoxidharz,

(B) eine epoxidgruppenhaltige Phosphorverbindung folgender Struktur:

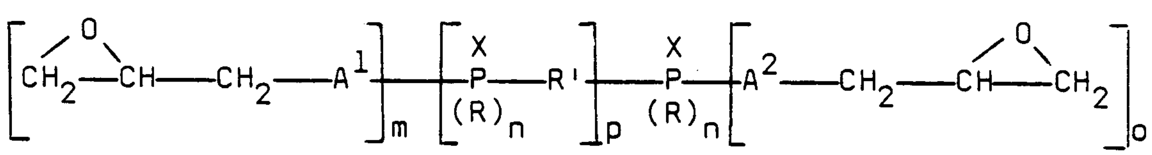

mit m = 0 oder 1, n = 0, 1 oder 2 und o = 1, 2 oder 3, wobei folgendes gilt: m + n + o = 3, und mit p = 0, 1 oder 2;

| | |
|---|---|
| X | bedeutet ein freies Elektronenpaar oder ein über eine Doppelbindung gebundenes O- oder S-Atom, |
| R | bedeutet einen direkt oder über O oder S gebundenen Alkylrest mit 1 bis 4 C-Atomen, Alkenylrest mit 2 bis 3 C-Atomen, Arylrest, wie Phenyl, Alkoxyphenyl, Nitrophenyl, Naphthyl und Biphenyl, Aralkylrest, wie Benzyl, Dialkylamino- oder Alkylarylaminorest oder 3-Trialkylsilyl-propylrest, |
| R' | bedeutet eine Brücke aus O, S, Phenylen, Dioxyphenylen, Dioxynaphthylen, $(CH_2)_r$, O-$(CH_2)_r$ oder O-$(CH_2)_r$-O mit r = 1 bis 3, und |
| $A^1$ und $A^2$, | die gleich oder verschieden sein können, bedeuten eine Einfachbindung oder eine |

Brücke entsprechend der Gruppierung R'; und
(C) eine aromatisches Polyamin folgender Struktur als Härter:

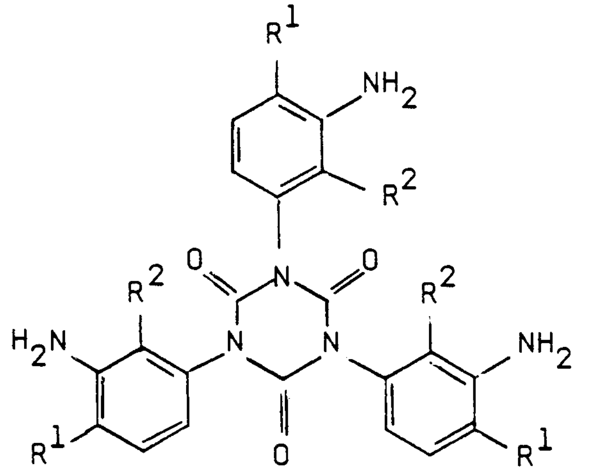

,

wobei an jeder der drei aromatischen Partialstrukturen jeweils einer der Reste $R^1$ und $R^2$ H und der andere Alkyl bedeutet.

Es wurde nämlich völlig überraschend gefunden, daß bei Verwendung einer Kombination aus Komponenten der vorstehend genannten Art, d.h. aus (phosphatfreien) aromatischen und/oder heterocyclischen Polyepoxidharzen, epoxidgruppenhaltigen Phosphorverbindungen und Polyaminen (als Härter), sowohl die Schwerbrennbarkeit als auch die mechanische Festigkeit der daraus erhaltenen Reaktionsharzformstoffe deutlich gesteigert wird. Es wurde außerdem überraschend gefunden, daß sich die erfindungsgemäße Kombination aus den Komponenten (A), (B) und (C) kostengünstig und vergleichbar oder sogar besser als die im technischen Einsatz befindlichen Epoxidharze verarbeiten läßt. Die im Stand der Technik als notwendig beschriebene Vorreaktion flüssiger oder kristalliner epoxidgruppenhaltiger Phosphorverbindungen mit Bisphenolen oder Dicarbonsäuren ist somit nicht erforderlich.

Als Polyepoxidharz, d.h. Polyglycidylverbindung, eignen sich insbesondere folgende Verbindungen: aromatische Polyglycidylether, wie Bisphenol-A-diglycidylether, Bisphenol-F-diglycidylether und Bisphenol-S-diglycidylether, Polyglycidylether von Phenol/Formaldehyd-Harzen und Kresol/Formaldehyd-Harzen, Resorcindiglycidylether und Tetrakis(p-glycidylphenyl)-ethan, Di-bzw. Polyglycidylester von Phthal-, Isophthal- und Terephthalsäure sowie von Trimellithsäure, N-Glycidylverbindungen von aromatischen Aminen und heterocyclischen Stickstoffbasen, wie N.N-Diglycidylanilin, N.N.O-Triglycidyl-p-aminophenol, Triglycidylisocyanurat und N.N.N'.N'-Tetraglycidyl-bis(p-aminophenyl)-methan, Hydantoin-Epoxidharze und Uracil-Epoxidharze sowie Di- und Polyglycidylverbindungen von mehrwertigen aliphatischen Alkoholen, wie 1.4-Butandiol, Trimethylolpropan und Polyalkylenglykolen. Desweiteren sind als Komponente (A) auch modifizierte Epoxidharze geeignet, beispielsweise oxazolidinonmodifizierte Epoxidharze. Derartige Verbindungen sind bereits bekannt (siehe: "Angew. Makromol. Chem.", Bd. 44 (1975), Seiten 151 bis 163, sowie US-PS 3 334 110); beispielhaft sie hierfür das Umsetzungsprodukt von Bisphenol-A-diglycidylether mit Diphenylmethandiisocyanat (in Gegenwart eines geeigneten Beschleunigers) genannt. Als weitere Beispiele für modifizerte Epoxidharze seien die Umsetzungsprodukte von Epoxidharzen mit aminmodifizierten Bismaleinimiden genannt. Die Polyepoxidharze können in den erfindungsgemäßen Epoxidharzmischungen einzeln oder im Gemisch vorliegen. Bevorzugt wird als Polyepoxidharz ein epoxidierter Novolak, vorzugsweise mit einem Gehalt an hydrolysierbarem Halogen $<0.1$ %, verwendet.

Auch die Komponente (B) kann sowohl in Form einzelner Verbindungen als auch in Form eines Gemisches mehrerer Verbindungen zum Einsatz gelangen. Als Komponente (B) eignen sich beispielsweise folgende epoxidgruppenhaltige Phosphorverbindungen, die sämtlich bereits bekannt sind: Methyl-diglycidyl-phosphonat, Ethyl-diglycidyl-phosphonat, Propyl-diglycidyl-phosphonat, Butyl-diglycidyl-phosphonat, Vinyldiglycidyl-phosphonat, Phenyl-diglycidyl-phosphonat und Biphenyl-diglycidyl-phosphonat; Methyl-diglycidyl-phosphat, Ethyl-diglycidyl-phosphat, n-Propyl-diglycidyl-phosphat, n-Butyl-diglycidyl-phosphat, Isobutyl-diglycidyl-phosphat, Allyl-diglycidyl-phosphat, Phenyl-diglycidyl-phosphat, p-Methoxyphenyl-diglycidyl-phosphat, p-Ethoxyphenyl-diglycidyl-phosphat, p-Propyloxyphenyl-diglycidyl-phosphat, p-Isopropyloxyphenyl-diglycidyl-phosphat, Phenylthio-diglycidyl-phosphat, Triglycidyl-phosphat, Tris(glycidylethyl)phosphat, p-Glycidylphenyl-ethyl-glycidyl-phosphat und Benzyl-diglycidyl-thiophosphat.

Die Synthese dieser Verbindungen erfolgt beispielsweise durch Umsetzung von Phosphonsäure- oder Phosphorsäurechloriden mit Glycidol (siehe: "Zh. Obshch. Khim.", Bd. 54, Heft 10 (1984), Seiten 2404 ff.), durch Umsetzung von Phosphorsäure oder Phosphonsäuren mit Epichlorhydrin (JP-OS 51-143620) oder durch Epoxidierung von Phosphorverbindungen, die Reste mit olefinischen Doppelbindungen enthalten (US-PS 2 856 369).

Das Mischungsverhältnis der Komponenten (A) und (B) läßt sich - entsprechend dem gewünschten Eigenschaftsspektrum - in einem breiten Bereich variieren. Für gewisse Anwendungen ist es sogar möglich, auf die Komponente (A) ganz zu verzichten. Vorteilhaft beträgt das Mischungsverhältnis von (A) zu (B) bei den erfindungsgemäßen Epoxidharzmischungen 10:1 bis 1:10 und vorzugsweise 4:1 bis 1:4, insbesondere 2:1 bis 1:2.

Die in den erfindungsgemäßen Epoxidharzmischungen als Härter dienenden aromatischen Polyamine sind zum Teil bereits bekannt. Polyamine der angegebenen Struktur mit $R^1$ = Alkyl und $R^2$ = H sind in der EP-OS 0 274 646 beschrieben. Sie werden durch Trimerisierung von 2.4-Diisocyanato-alkylbenzolen und nachfolgende Hydrolyse der verbleibenden Isocyanatgruppen hergestellt. Verbindungen mit $R^1$ = H und $R^2$ = Alkyl werden analog durch Trimerisierung von 2.6-Diisocyanato-alkylbenzolen und nachfolgende Hydrolyse erhalten. Als Komponente (C) können in den erfindungsgemäßen Epoxidharzmischungen sowohl Polyamine der beiden vorstehend genannten Arten als auch Gemische dieser Verbindungen verwendet werden. Darüber hinaus können auch Polyamine eingesetzt werden, die durch Trimerisierung von Gemischen aus 2.4- und 2.6-Diisocyanato-alkylbenzolen und nachfolgende Hydrolyse der Trimerisate erhalten werden. Derartige Gemische sind großtechnisch zugänglich und erlauben eine kostengünstige Herstellung der Härterkomponente.

Bei der Hydrolyse der isocyanatgruppenhaltigen Trimerisierungsprodukte kann es auch zu einer Reaktion zwischen Isocyanatgruppen und Aminogruppen kommen. Dabei werden, als Nebenprodukt der Hydrolysereaktion, heterocyclische Polyamine mit Harnstoffgruppierungen erhalten. Derartige Polyamine können in den erfindungsgemäßen Epoxidharzmischungen als additive Härterkomponente eingesetzt werden, d.h. im Gemisch mit dem eigentlichen Härter zum Einsatz gelangen. Neben dem eigentlichen Härter bzw. neben Härtergemischen der vorstehend genannten Art können in den Epoxidharzgemischen auch aromatische Polyamine anderer Art, wie 4.4'-Diaminodiphenylmethan und 4.4'-Diaminodiphenylsulfon, und/oder andere heterocyclische Polyamine eingesetzt werden. Der Anteil derartiger Polyamine im Härtergemisch beträgt im allgemeinen maximal 30 Masse-%.

Das Verhältnis zwischen eingesetzter Epoxid-Funktion (Komponenten A und B) und eingesetzter Aminwasserstoff-Funktion NH (Komponente C) kann bei den erfindungsgemäßen Epoxidharzmischungen 0,9:1 bis 1,5:1 betragen, vorteilhaft beträgt es 0,9:1 bis 1,1:1 und vorzugsweise etwa 1:1.

Zur Prepregherstellung werden die einzelnen Komponenten getrennt oder zusammen in kostengünstigen Lösungsmitteln, wie Aceton, Methylethylketon, Ethylacetat, Methoxyethanol und Dimethylformamid, oder in Gemischen derartiger Lösungsmittel gelöst, gegebenenfalls zu einer Lösung vereinigt und auf gängigen Imprägnieranlagen verarbeitet, d.h. zum Tränken von Fasern aus anorganischen oder organischen Materialien, wie Glas, Metall, Mineralien, Kohlenstoff, Aramid, Polyphenylensulfid und Cellulose, sowie von daraus hergestellten Geweben oder Vliesen oder zum Beschichten von Flächenstoffen, wie Folien aus Metallen oder Kunststoffen, eingesetzt. Die imprägnierten oder beschichteten Verstärkungsmaterialien bzw. Einlagerungskomponenten werden dann bei erhöhter Temperatur getrocknet, wobei einerseits das Lösungsmittel entfernt wird und andererseits eine Vorpolymerisation des Polyepoxidharzes erfolgt. Insgesamt ergibt sich auf diese Weise ein außerordentlich günstiges Verhältnis von Aufwand zu erzielbaren Eigenschaften.

Die auf die vorstehend geschilderte Weise hergestellten Beschichtungen und Prepregs sind nichtklebend und bei Raumtemperatur für die Dauer von drei Monaten und mehr lagerstabil, d.h. sie weisen eine ausreichende Lagerstabilität auf. Sie lassen sich bei Temperaturen bis zu 200°C zu Verbundwerkstoffen verpressen, die sich durch eine hohe Glasübergangstemperatur von 250 bis 300°C und durch inhärente Schwerbrennbarkeit auszeichnen. Verwendet man als Einlagerungsmaterial beispielsweise Glasgewebe mit einem Masseanteil von 60 bis 62 %, so wird die Brennprüfung nach UL 94V ohne Zusatz von Halogenverbindungen oder sonstigen flammhemmenden Zusatzstoffen, selbst bei Prüfkörpern mit einer Wandstärke von 1,6 mm oder sogar nur 0,8 mm, mit einer sicheren V-O-Einstufung bestanden. Dabei erweist es sich als besonders vorteilhaft, daß sich keine korrosiven oder besonders toxischen Spaltprodukte bilden, und daß die Rauchentwicklung im Vergleich zu anderen Polymerwerkstoffen, insbesondere zu bromhaltigen Epoxidharz-Formstoffen, stark vermindert ist.

Die ausgehärteten Verbundwerkstoffe zeichnen sich ferner durch einen über einen weiten Temperaturbereich konstant kleinen thermischen Ausdehnungskoeffizienten sowie durch hohe Chemikalienbeständigkeit, Korrosionsbeständigkeit, geringe Wasseraufnahme und sehr gute elektrische Eigenschaftswerte aus;

die Haftung zu den verstärkenden und zu verbindenden Materialien ist ausgezeichnet. Bei Verwendung von Verstärkungsmaterialien der genannten Art werden Prepregs für mechanisch hoch beanspruchbare Konstruktionswerkstoffe erhalten. Diese Konstruktionswerkstoffe eignen sich beispielsweise für Anwendungen im Maschinenbau, im Fahrzeugbau, in der Flugtechnik und in der Elektrotechnik, beispielsweise in Form von Prepregs für die Leiterplattenherstellung, insbesondere auch zur Herstellung von Multilayer-Schaltungen.

Von besonderem Vorteil für die Verwendung als Leiterplattenmaterial ist die hohe Haftfestigkeit von Leiterbahnen aus Kupfer, die hohe Delaminierfestigkeit und eine ausgezeichnete Bearbeitbarkeit, die sich beispielsweise beim Bohren von Durchkontaktierungslöchern darin zeigt, daß einwandfreie Bohrungen bei geringem Bohrerverschleiß erhalten werden. Damit können bei den erfindungsgemäß hergestellten Materialien zwei- und mehrlagige Leiterplatten sicherer bzw. kostengünstiger hergestellt werden als mit Materialien, die den derzeitigen Stand der Technik repräsentieren. Bei den gegenwärtig in der Leiterplattentechnik im breiten Umfang eingesetzten FR4-Materialien müssen Bohrungen für die anschließende elektrisch leitende Verbindung der Kupferlagen nachträglich freigeätzt werden. Bei Leiterplattenmaterialien auf Polyimidbasis muß, abgesehen vom höheren Materialpreis und einer aufwendigeren Prozeßtechnik bei der Leiterplattenherstellung, mit einem höheren Bohrerverschleiß gerechnet werden.

Anhand von Ausführungsbeispielen soll die Erfindung noch näher erläutert werden.

Beispiel 1: Herstellung von Prepregs

Eine Lösung von A Massenteilen (MT) eines epoxidierten Novolaks (mit einem Epoxidwert von 0,57) in B Masseteilen Ethylmethylketon wird mit einer Lösung von C Masseteilen eines Polyamins, das durch Trimerisierung einer 4:1-Mischung aus Toluol-2.4-diisocyanat und Toluol-2.6-diisocyanat und nachfolgende Hydrolyse zu einem Produkt mit einem $NH_2$-Wert von 8,7 % hergestellt wurde, in D Masseteilen Ethylmethylketon und mit E Masseteilen Phenyl-diglycidyl-phosphonat (zur Herstellung siehe: "Zh. Obshch. Khim.", Bd. 54, Heft 10 (1984), Seiten 2404 ff.) versetzt. Die Zusammensetzung verschiedener Epoxidharzmischungen ist Tabelle 1 zu entnehmen. Mit diesen Mischungen wurden Glasgewebe (Leinwandbindung, Flächengewicht: 197 g/m$^2$) kontinuierlich imprägniert und in einer Vertikaltrockenanlage bei Temperaturen von 50 bis 130 °C getrocknet. Derart hergestellte Prepregs sind klebfrei und bei Raumtemperatur länger als 3 Monate lagerstabil.

Tabelle 1

| Versuchs-Nr. | 1 | 2 | 3 | 4 | 5 |
|---|---|---|---|---|---|
| Komponenten: | | | | | |
| A (MT) | 66 | 48 | 42 | 34 | 0 |
| B (MT) | 18 | 16 | 14 | 11 | 0 |
| C (MT) | 34 | 36 | 36 | 36 | 40 |
| D (MT) | 34 | 28 | 28 | 24 | 34 |
| E (MT) | 0 | 16 | 22 | 30 | 60 |
| Prepreg: | | | | | |
| Restgehalt an Lösungsmittel (%) | 0,5 | 0,4 | 0,3 | 0,3 | < 0,2 |
| Restgelierzeit bei 170 °C (s) | 47 | 60 | 65 | 71 | 61 |

Um mit dem Stand der Technik vergleichen zu können, wurde in einem weiteren Versuch das Polyamin durch den technisch bislang am meisten verwendeten Härter Dicyandiamid ersetzt. Dazu wurden 60 Masseteile Phenyl-diglycidyl-phosphonat mit einer Lösung von 9 Masseteilen Dicyandiamid in 15 Masseteilen Dimethylformamid und mit 0,9 Masseteilen Dimethylbenzylamin versetzt. Mit der dabei erhaltenen Lösung wurde versucht, ein Glasgewebe (Leinwandbindung, Flächengewicht: 197 g/m$^2$) kontinuierlich zu imprägnieren und bei Temperaturen von 50 bis 160 °C durch eine Vertikaltrockenanlage zu führen. Es erwies sich aber, trotz Variation von Ziehgeschwindigkeit und Temperaturprofil, als nicht möglich, Prepregs herzustellen, da das Harz bei den Trockenbedingungen dünnflüssig wurde und vom Glasgewebe herunterfloß. Versuche zeigten, daß das abtropfende, von Lösungsmittelresten befreite Harz selbst nach 45 min bei 160 °C und nachfolgenden 120 min bei 180 °C im Trockenschrank nicht gehärtet werden kann. Auf eine weitere Beurteilung dieses Systems wurde deshalb verzichtet.

Beispiel 2: Herstellung von Laminaten

Je 8 der nach Beispiel 1 erhaltenen Prepregs werden in einer Presse bei 175 °C und 70 bar verpreßt. Die 1,6 mm dicken Laminate werden nach 10 min aus der Presse entfernt und anschließend 2 h bei 200 °C nachgehärtet. Die auf diese Weise erhaltenen Körper werden auf ihre Glasübergangstemperatur ($T_G$) und die Brennbarkeit nach UL 94V geprüft. Die Werte sind in Tabelle 2 zusammengestellt (die Versuchsnummern entsprechen denen von Beispiel 1).

Tabelle 2

| Versuchs-Nr. | 1 | 2 | 3 | 4 | 5 |
|---|---|---|---|---|---|
| Meßwerte: | | | | | |
| $T_G$ (°C) | 230 | 250 | 260 | 260 | 260 |
| mittlere Brenndauer nach UL 94V (s) | > 40 | 4,5 | 1,4 | < 1 | 0 |
| Einstufung | nicht möglich | V-0 | V-0 | V-0 | V-0 |

Beispiel 3: Herstellung von Leiterplattenbasismaterial

Stapel von je 8 Lagen der nach Beispiel 1 hergestellten Prepregs werden mit je einer Kupferfolie (Dicke: 18 µm) oben und unten belegt und bei 175 °C und 70 bar 30 min verpreßt. Dieses sogenannte Basismaterial wird danach 2 h in einem Ofen bei 200 °C nachgehärtet. Tabelle 3 enthält die an diesen Materialien gemessenen Prüfwerte (die Versuchsnummern entsprechen denen von Beispiel 1).

Tabelle 3

| Versuchs-Nr. | 2 | 3 | 4 |
|---|---|---|---|
| Meßwerte: | | | |
| Haftvermögen der Cu-Folie bei RT (N/mm) | 1,5 | 1,6 | 1,6 |
| Kugeltest zur Beurteilung der Lagenbindung | + | + | + |
| Lötbadtest bei 288 °C/20 s | + | + | + |
| Wasseraufnahme (mg) | 14 | 16 | 16 |
| Oberflächenwiderstand (Ohm) | $8.10^{13}$ | $8.10^{13}$ | $8.10^{13}$ |
| Dielektrizitätkonstante (1 MHz) | 4,82 | 4,88 | 4,85 |
| mittlere Brenndauer nach IEC 249-1 (s) | 2,4 | 1,2 | < 1 |
| Schneidbarkeit nach DIN 53488 | + | + | + |
| Bohrer-Verschleißprüfung | + | + | + |
| Nach Strukturierung der Cu-Lagen: | | | |
| Oberflächenkorrosion nach IPC-B-25 | + | + | + |
| Schnittkantenkorrosion nach IEC 249-1 | + | + | + |
| (" + " bedeutet: bestanden) | | | |

Beispiel 4

38 Masseteile eines epoxidierten Novolaks (mit einem Epoxidwert von 0,57) werden in 14 Masseteilen Ethylmethylketon gelöst und mit einer Lösung von 14 Masseteilen eines entsprechend Beispiel 1 hergestellten Polyamins (mit einem $NH_2$-Wert von 8,7 %) in 30 Masseteilen Ethylmethylketon sowie mit 22 Masseteilen Triglycidylphosphat (zur Herstellung siehe: "Plaste und Kautschuk", Bd. 11 (1964), Seiten 515 ff.) versetzt. Die erhaltene Lösung wird, wie in Beispiel 1 beschrieben, zu Prepregs verarbeitet. Der Restlösungsmittelgehalt der Prepregs beträgt 0,3 %, die Gelierzeit bei 170 °C ist 35 s. Die Prepregs sind nach der Trocknung klebfrei und bei Raumtemperatur mehr als 3 Monate lagerstabil.

Je 8 Prepregs werden in einer Presse bei 175 °C und 70 bar verpreßt. Die 1,6 mm dicken Laminate werden nach 10 min aus der Presse entfernt und anschließend 2 h bei 200 °C nachgehärtet. Die Glasübergangstemperatur der auf diese Weise erhaltenen Körper beträgt 300 °C.

Beispiel 5

Zu einer 80 %igen Lösung von 175 Masseteilen eines epoxidierten Novolaks (Epoxidwert: 0,57) in Ethylmethylketon gibt man eine 60 %ige Lösung von 183 Massenteilen eines Polyamins entsprechend Beispiel 1 (mit einem $NH_2$-Wert von 8,7 %) in Ethylmethylketon sowie unterschiedliche Masseteile einer glycidylgruppenhaltigen Phosphorverbindung (siehe Tabelle 4). Die dabei erhaltene Lösung weist in den meisten Fällen eine für die Verarbeitung zu Prepregs zu hohe Viskosität auf und wird deshalb direkt an der Imprägnieranlage mit weiterem Ethylmethylketon soweit verdünnt, daß sich bei der Tränkung von Glasgewebe (Leinwandbindung, Flächengewicht: 197 $g/m^2$) und der nachfolgenden Vertikaltrocknung bei 50 bis 130 °C 0,22 bis 0,23 mm starke Prepregs herstellen lassen. Die Prepregs sind nach der Trocknung klebfrei und bei Raumtemperatur mehr als 3 Monate lagerstabil.

Je 8 Prepregs werden in einer Presse bei 175 °C und 70 bar verpreßt. Die 1,6 mm dicken Laminate werden nach 10 min aus der Presse entfernt und anschließend 2 h bei 200 °C nachgehärtet. Tabelle 4 enthält die an den Laminaten gemessenen Werte.

Tabelle 4

| Versuchs-Nr. | 6 | 7 | 8 | 9 | 10 | 11 |
|---|---|---|---|---|---|---|
| Komponenten zur Prepreg-Herstellung: | | | | | | |
| epoxidierter Novolak (MT) | 175 | 175 | 175 | 175 | 175 | 175 |
| Polyamin (MT) | 183 | 183 | 183 | 183 | 183 | 183 |
| Methyl-diglycidyl-phosphonat[1)] (MT) | 104 | - | - | - | - | - |
| Ethyl-diglycidyl-phosphonat[1)] (MT) | - | 111 | - | - | - | - |
| Methyl-diglycidyl-phosphat[2)] (MT) | - | - | 112 | - | - | - |
| Ethyl-diglycidyl-phosphat[2)] (MT) | - | - | - | 119 | - | - |
| Phenyl-diglycidyl-phosphat[2)] (MT) | - | - | - | - | 143 | - |
| p-Methoxyphenyl-diglycidyl-phosphat[2)] (MT) | - | - | - | - | - | 158 |
| Meßwerte am Laminat: | | | | | | |
| Glasübergangstemperatur $T_G$ (°C) | 270 | 270 | 260 | 260 | 270 | 260 |
| mittlere Brenndauer nach UL 94V (s) | 2,5 | 4,0 | 2,0 | 3,1 | < 1 | 2,0 |
| Einstufung | V-0 | V-0 | V-0 | V-0 | V-0 | V-0 |

1) siehe: "Zh. Obshch. Khim." 54 (10), 2404 (1984) bzw. C.A. 102 (19), 166845d

2) siehe: "Isv. Akad. Nauk. SSSR", Ser. Khim. (9), 2006 (1967) bzw. C.A. 68 (7), 29789d

Beispiel 6

Zu einer 80 %igen Lösung unterschiedlicher Masseteile eines Epoxidharzes (siehe Tabelle 5) in Ethylmethylketon gibt man eine 60 %ige Lösung von 183 Masseteilen eines Polyamins entsprechend

Beispiel 1 (mit einem $NH_2$-Wert von 8,7 %) in Ethylmethylketon sowie 135 Masseteile Phenyl-diglycidylphosphonat. Die dabei erhaltene Lösung hat in den meisten Fällen eine für die Verarbeitung zu Prepregs zu hohe Viskosität und wird deshalb direkt an der Imprägnieranlage mit weiterem Ethylmethylketon soweit verdünnt, daß sich bei der Tränkung von Glasgewebe (Leinwandbindung, Flächengewicht: 197 $g/m^2$) und der nachfolgenden Vertikaltrocknung bei 50 bis 130 °C 0,22 bis 0,23 mm starke Prepregs herstellen lassen. Die Prepregs sind nach der Trocknung klebfrei und mehr als 3 Monate lagerstabil.

Je 8 Prepregs werden in einer Presse bei 175 °C und 70 bar verpreßt. Die 1,6 mm dicken Laminate werden nach 10 min aus der Presse entfernt und anschließend 2 h bei 200 °C nachgehärtet. Tabelle 5 enthält die an diesen Materialien gemessenen Werte.

Tabelle 5

| Versuchs-Nr. | 12 | 13 | 14 | 15 | 16 |
|---|---|---|---|---|---|
| Komponenten zur Prepreg-Herstellung: | | | | | |
| epoxidierter Novolak[1] (MT) | 185 | 93 | - | - | - |
| oxazolidinonmodifiziertes Epoxidharz[2] (MT) | - | 238 | - | - | - |
| Bisphenol-A-diglycidylether[3] (MT) | - | - | 175 | - | - |
| Bisphenol-F-diglycidylether[4] (MT) | - | - | - | 164 | - |
| Hydantoin-Epoxidharz[5] (MT) | - | - | - | - | 175 |
| Polyamin (MT) | 183 | 183 | 183 | 183 | 183 |
| Phenyl-diglycidyl-phosphonat (MT) | 135 | 135 | 135 | 135 | 135 |
| Meßwerte am Laminat: | | | | | |
| Glasübergangstemperatur $T_G$ (°C) | 275 | 230 | 260 | 255 | 270 |
| mittlere Brenndauer nach UL 94V (s) | 1,2 | 4,2 | 2,2 | 1,5 | 3,0 |
| Einstufung | V-0 | V-0 | V-0 | V-0 | V-0 |

1) Epoxidwert: 0,54; Viskosität bei 150°C: 600 cSt
2) Epoxidwert: 0,21
3) Epoxidwert: 0,57; Viskosität bei 25°C: 4000 bis 6000 mPa.s
4) Epoxidwert: 0,61; Viskosität bei 25°C: 1200 ± 100 mPa.s
5) Epoxidwert: 0,57; Viskosität bei 80°C: 9000 mPa.s

## Patentansprüche

1. Epoxidharzmischungen zur Herstellung von Prepregs und Verbundwerkstoffen, **dadurch gekennzeichnet,** daß sie folgende Komponenten enthalten:

(A) ein phosphorfreies aromatisches und/oder heterocyclisches Polyepoxidharz, gegebenenfalls in Abmischung mit einem aliphatischen Epoxidharz,

(B) eine epoxidgruppenhaltige Phosphorverbindung folgender Struktur:

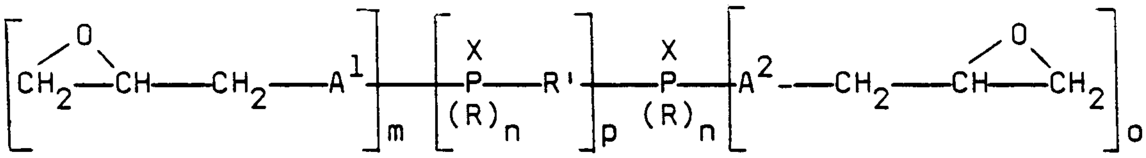

mit m = 0 oder 1, n = 0, 1 oder 2 und o = 1, 2 oder 3, wobei folgendes gilt: m + n + o = 3, und mit p = 0, 1 oder 2;

| | |
|---|---|
| X | bedeutet ein freies Elektronenpaar oder ein über eine Doppelbindung gebundenes O- oder S-Atom, |
| R | bedeutet einen direkt oder über O oder S gebundenen Alkylrest mit 1 bis 4 C-Atomen, Alkenylrest mit 2 bis 3 C-Atomen, Arylrest, Aralkylrest, Dialkylamino- oder Alkylarylaminorest oder 3-Trialkylsilyl-propylrest, |
| R' | bedeutet eine Brücke aus O, S, Phenylen, Dioxyphenylen, Dioxynaphthylen, $(CH_2)_r$, $O-(CH_2)_r$ oder $O-(CH_2)_r-O$ mit r = 1 bis 3, und |
| $A^1$ und $A^2$, | die gleich oder verschieden sein können, bedeuten eine Einfachbindung oder eine Brücke entsprechend der Gruppierung R'; und |

(C) ein aromatisches Polyamin folgender Struktur als Härter:

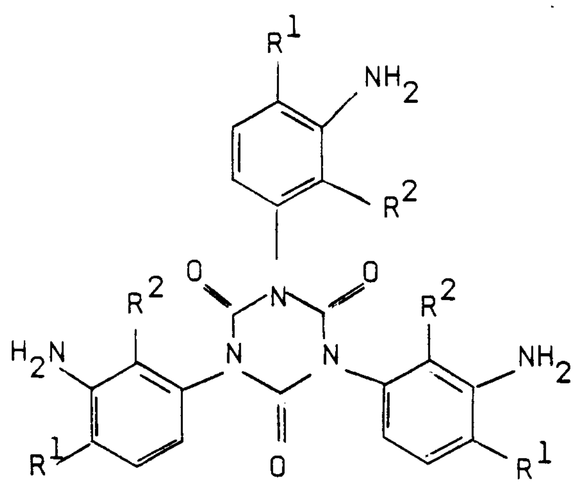

,

wobei an jeder der drei aromatischen Partialstrukturen jeweils einer der Reste $R^1$ und $R^2$ H und der andere Alkyl bedeutet.

**2.** Epoxidharzmischungen nach Anspruch 1, **dadurch gekennzeichnet,** daß die Komponente (B) ein Di- oder Triglycidylester der Phosphorsäure oder ein Gemisch dieser Verbindungen ist.

**3.** Epoxidharzmischungen nach Anspruch 1, **dadurch gekennzeichnet,** daß die Komponente (B) ein Diglycidylester einer Alkyl- oder Arylphosphonsäure ist.

**4.** Epoxidharzmischungen nach Anspruch 1, **dadurch gekennzeichnet,** daß die Komponente (B) ein Di- oder Triglycidylester der phosphorigen Säure oder ein Gemisch dieser Verbindungen ist.

**5.** Epoxidharzmischungen nach einem der Ansprüche 1 bis 4, **dadurch gekennzeichnet,** daß das Verhältnis der Komponente (A) zur Komponente (B) 10:1 bis 1:10 beträgt, vorzugsweise 4:1 bis 1:4.

**6.** Epoxidharzmischungen nach einem oder mehreren der Ansprüche 1 bis 5, **dadurch gekennzeichnet,** daß das Verhältnis zwischen Epoxid-Funktion und Aminwasserstoff-Funktion 0,9:1 bis 1,1:1 beträgt, vorzugsweise etwa 1:1.

7. Epoxidharzmischungen nach einem oder mehreren der Ansprüche 1 bis 6, **dadurch gekennzeichnet,** daß die Komponente (C) ein Gemisch von Polyaminen ist, hergestellt durch Trimerisierung eines Gemisches aus 2.4- und 2.6-Diisocyanato-alkylbenzolen und nachfolgende Hydrolyse.

8. Epoxidharzmischungen nach einem oder mehreren der Ansprüche 1 bis 7, **dadurch gekennzeichnet,** daß die Komponente (C) im Gemisch mit weiteren aromatischen und/oder heterocyclischen Polyaminen als Härter vorliegt.

9. Epoxidharzmischungen nach Anspruch 8, **dadurch gekennzeichnet,** daß der Anteil der Komponente (C) im Härtergemisch wenigstens 70 Masse-% beträgt.

10. Epoxidharzmischungen nach einem oder mehreren der Ansprüche 1 bis 9, **dadurch gekennzeichnet,** daß das Polyepoxidharz ein epoxidierter Novolak ist, vorzugsweise mit einem Gehalt an hydrolysierbarem Halogen < 0,1 Masse-%.

11. Prepregs und Verbundwerkstoffe auf der Basis von anorganischen oder organischen Verstärkungsmaterialien in Form von Fasern, Vliesen oder Geweben bzw. von Flächenstoffen, hergestellt aus Epoxidharzmischungen nach einem oder mehreren der Ansprüche 1 bis 10.

12. Leiterplatten aus Prepregs, hergestellt aus Glasfasergewebe und Epoxidharzmischungen nach einem oder mehreren der Ansprüche 1 bis 10.

## Claims

1. Epoxy resin compounds for preparing prepregs and composite materials, characterised in that they contain the following constituents:
   (A) an aromatic and/or heterocyclic polyepoxide resin that is free of phosphorus, optionally in a mixture with an aliphatic epoxy resin;
   (B) an epoxy-group-containing phosphorus compound of the following structure:

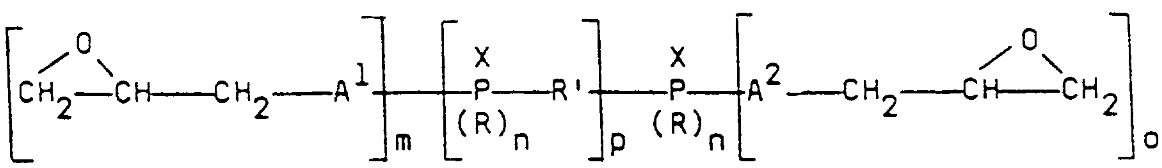

   with m = 0 or 1, n = 0, 1 or 2 and o = 1, 2 or 3, where the following applies: m + n + o = 3, and with p = 0, 1 or 2;

   | | |
   |---|---|
   | X | denotes a free electron pair or an O- or S-atom linked via a double bond; |
   | R | denotes an alkyl residue having 1 to 4 C-atoms; alkenyl residue having 2 to 3 C-atoms; aryl residue; aryl alkyl residue; dialkyl-amino residue or alkyl-aryl-amino residue or 3-trialkylsilylpropyl residue, linked directly or via O or S; |
   | R' | denotes a bridge of O, S, phenylene, dioxyphenylene, dioxynaphthylene, $(CH_2)_r$, O-$(CH_2)_r$ or O-$(CH_2)_r$-O with r = 1 to 3; and |
   | $A^1$ and $A^2$, | which can be the same or different, denote a single bond or a bridge according to the grouping R'; and |

(C) an aromatic polyamine of the following structure as a curing agent:

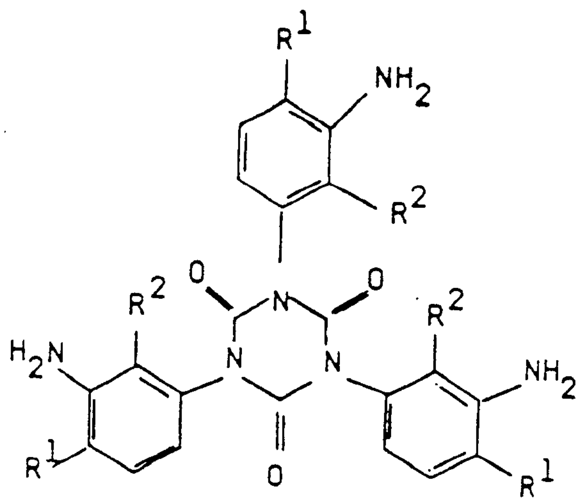

where on each of the three aromatic partial structures, one of the residues $R^1$ and $R^2$ respectively denotes H and the other alkyl.

2. Epoxy resin compounds according to claim 1, characterised in that the constituent (B) is a di- or triglycidylester of phosphoric acid or a mixture thereof.

3. Epoxy resin compounds according to claim 1, characterised in that the constituent (B) is a diglycidylester of an alkyl- or arylphosphonic acid.

4. Epoxy resin compounds according to claim 1, characterised in that the constituent (B) is a di- or triglycidylester of phosphorous acid or a mixture thereof.

5. Epoxy resin compounds according to one of the claims 1 to 4, characterised in that the ratio of the constituent (A) to the constituent (B) is from 10:1 to 1:10, preferably 4:1 to 1:4.

6. Epoxy resin compounds according to one or several of the claims 1 to 5, characterised in that the ratio of the epoxy function to the amine-hydrogen function is from 0.9:1 to 1.1:1, preferably approximately 1:1.

7. Epoxy resin compounds according to one or several of the claims 1 to 6, characterised in that the constituent (C) is a mixture of polyamines, prepared by trimerization of a mixture of 2.4- and 2.6-diisocyanato-alkylbenzene and by subsequent hydrolysis.

8. Epoxy resin compounds according to one or several of the claims 1 to 7, characterised in that the constituent (C) is present as a curing agent in a mixture with further aromatic and/or heterocyclic polyamines.

9. Epoxy resin compounds according to claim 8, characterised in that the proportion of constituent (C) in the curing agent mixture is at least 70 % by weight.

10. Epoxy resin compounds according to one or several of the claims 1 to 9, characterised in that the polyepoxide resin is an epoxidised novolak, preferably having a concentration of hydrolyzable halogen of < 0.1 % by weight.

11. Prepregs and composite materials based on inorganic or organic reinforcing materials in the form of fibres, fleece or cloth or in the form of fabrics prepared from epoxy resin compounds according to one or several of the claims 1 to 10.

12. Printed-circuit boards made of prepregs, prepared from a glass fibre cloth and epoxy resin compounds according to one or several of the claims 1 to 10.

**Revendications**

1. Mélanges à base de résine époxyde pour préparer des préimprégnés et des matériaux composites, caractérisés en ce q'ils contiennent les constituants suivants :
   (A) une résine de polyépoxyde aromatique et/ou hétérocyclique, exempte de phosphore, le cas échéant, en mélange avec une résine époxyde aliphatiqe,
   (B) un composé phosphoré contenant des groupes époxydes et ayant la structure suivante

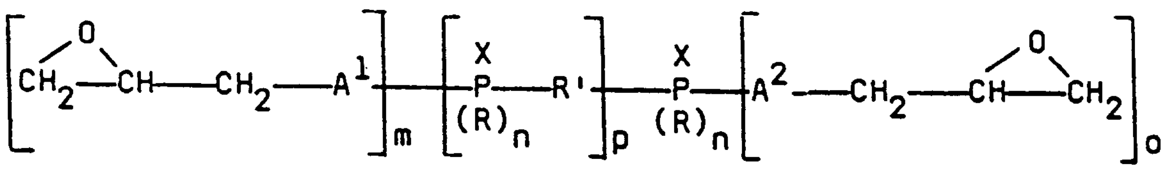

   avec m = 0 ou 1, n = 0, 1 ou 2 et o = 1, 2 ou 3, et satisfaisant aux relations : m + n + o = 3, et avec p = 0, 1 ou 2;

   | | |
   |---|---|
   | X | signifie une paire d'électrons libres ou un atome d'oxygène ou un atome de soufre relié par une double liaison, |
   | R | signifie un radical alcoyle ayant de 1 à 4 atomes de carbone, un radical alcényle ayant de 2 à 3 atomes de carbone, un radical aryle, un radical aralcoyle, un radical dialcoylamino ou alcoylarylamino ou un radical 3-trialcoylsilylpropyle, lié directement ou par l'intermédiaire de 0 ou de S, |
   | R' | signifie un pont constitué de 0, de S, de phénylène, de dioxyphénylène, de dioxynaphtylène, de $(CH_2)_r$, de $O-(CH_2)_r$ ou de $O-(CH_2)_r-O$ avec r = 1 à 3, et |
   | $A^1$ et $A^2$, | qui peuvent être identiques ou différents, signifient une simple liaison ou un pont correspondant au groupement R'; |

   (C) une polyamine aromatique ayant la structure suivante comme durcisseur :

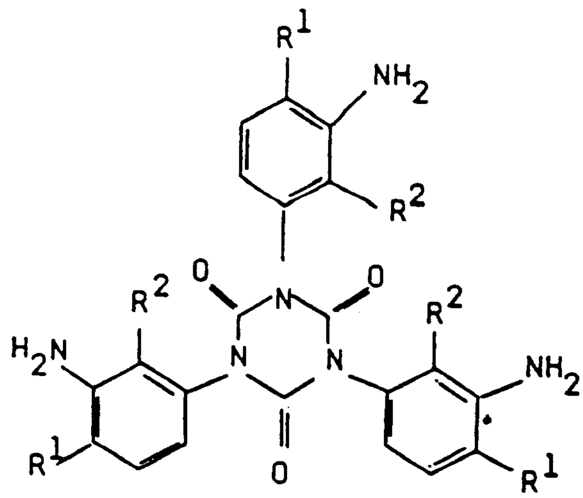
,

   l'un des radicaux $R^1$ et $R^2$ de chacune des trois structures aromatiques partielles étant H et l'autre étant alcoyle.

2. Mélanges à base de résine époxyde suivant la revendication 1, caractérisés en ce que le constituant (B) est un ester diglycidylique ou un ester triglycidylique de l'acide phosphorique ou un mélange de ces composés.

3. Mélanges à base de résine époxyde suivant la revendication 1, caractérisés en ce que le constituant (B) est un ester diglycidylique d'un acide alcoylphosphonique ou d'un acide arylphosphonique.

4. Mélanges à base de résine époxyde suivant la revendication 1, caractérisés en ce que le constituant (B) est un ester diglycidylique ou un ester triglycidylique de l'acide phosphoreux ou un mélange de ces composés.

5. Mélanges à base de résine époxyde suivant l'une des revendications 1 à 4, caractérisés en ce que le rapport du constituant (A) au constituant (B) est compris entre 10:1 et 1:10 et, de préférence, entre 4:1 et 1:4.

6. Mélanges à base de résine époxyde suivant l'une ou plusieurs des revendications 1 à 5, caractérisés en ce que le rapport entre la fonction époxyde et la fonction hydrogène d'amine est compris entre 0,9:1 et 1,1:1 et, de préférence, est de 1:1 environ.

7. Mélanges à base de résine époxyde suivant l'une ou plusieurs des revendications 1 à 6, caractérisés en ce que le constituant (C) est un mélange de polyamines, préparé par trimérisation d'un mélange de 2,4-diisocyanato-alcoylbenzène et de 2,6-diisocyanato-alcoylbenzène, suivie d'une hydrolyse.

8. Mélanges à base de résine époxyde suivant l'une ou plusieurs des revendications 1 à 7, caractérisés en ce que le constituant (C) est mélangé à d'autres polyamines aromatiques et/ou hétérocycliques servant de durcisseur.

9. Mélanges à base de résine époxyde suivant la revendication 8, caractérisés en ce que la proportion du constituant (C) dans le mélange durcisseur représente au moins 70 % en poids.

10. Mélanges à base de résine époxyde suivant l'une ou plusieurs des revendications 1 à 9, caractérisés en ce que la résine de polyépoxyde est une Novolaque époxydée ayant, de préférence, une teneur en halogène hydrolysable < 0,1 % en poids.

11. Préimprégnés et matériaux composites à base de renforts minéraux ou organiques sous forme de fibres, de nappes ou de tissus, ou de substance en feuilles, fabriqués en mélanges à base de résine époxyde suivant l'une ou plusieurs des revendications 1 à 10.

12. Plaquettes de circuits imprimés en préimprégnés, fabriquées en tissu de fibres de verre et en mélanges à base de résine époxyde suivant l'une ou plusieurs des revendications 1 à 10.